# EUROPEAN PATENT APPLICATION

(11) **EP 3 780 294 A1**
(43) Date of publication of application: **17.02.2021**
(21) Application number: 20181301.1
(22) Date of filing: 22.06.2020
(51) Int. Cl.: H01R 24/54, H01R 9/05

(54) **CONNECTOR ADAPTER AND CONNECTOR TEST SYSTEM**

(30) Priority: 14.08.2019 CN 201910748830
(71) Applicant: Tyco Electronics (Shanghai) Co., Ltd., Shanghai 201208 (CN)
(72) Inventor: Zhu, Liyun, Shanghai, 200233 (CN); Song, Zhigang, Shanghai, 200233 (CN); Zhai, Peng, Shanghai, 200233 (CN); Wang, Yunhe, Shanghai, 200233 (CN)
(74) Representative: Grünecker Patent- und Rechtsanwälte PartG mbB

(57) **Abstract**

Disclosed is a connector adapter including a first sub-adapter and a second sub-adapter. The first sub-adapter is adapted to be directly and electrically connected with a first end of a connector, so that the first end of the connector is allowed to be electrically connected to a first cable through the first sub-adapter and to a test equipment through the first cable. The second sub-adapter is adapted to be directly and electrically connected with a second end of the connector, so that the second end of the connector is allowed to be electrically connected to a second cable through the second sub-adapter and to the test equipment through the second cable. In the present disclosure, each end of the connector may be directly connected to the adapter without being connected to the adapter through a circuit board.

## Description

### CROSS-REFERENCE TO RELATED APPLICATION

This application claims the benefit of Chinese Patent Application No. 201910748830.5 filed on August 14, 2019 in the China National Intellectual Property Administration, the whole disclosure of which is incorporated herein by reference.

### BACKGROUND

### Field of the Disclosure

The present disclosure relates to a connector adapter and a connector test system comprising the connector adapter.

### Description of the Related Art

In the prior art, a coaxial RF connector generally comprises an external conductor, a central conductor disposed inside the external conductor, and an insulator disposed between the external conductor and the central conductor. During designing the coaxial RF connector, it is necessary to test the performance of the designed coaxial RF connector. The end of the coaxial RF connector is only suitable for electrical connection with a circuit board or a special electronic component, and cannot be directly connected with a coaxial RF cable. Therefore, in the prior art, in order to connect the coaxial RF connector to a test equipment, both ends of the coaxial RF connector need to be welded to the circuit boards respectively, and each circuit board is provided with a cable connector which is used to be electrically connected to the test equipment through the coaxial RF cable. In this way, the coaxial RF connector is electrically connected to the test equipment through the circuit board, the cable connector and the coaxial RF cable in this order.

However, in the prior art, it is difficult to completely remove the impact of the circuit board on each test project, resulting in inaccurate test results and test data. In addition, the coaxial RF connector cannot be removed from the circuit board, resulting in that the coaxial RF connector cannot be reused, thereby the cost is very high.

### SUMMARY

The present disclosure has been made to overcome or alleviate at least one aspect of the above mentioned and other problems and disadvantages.

According to an aspect of the present disclosure, there is provided a connector adapter, comprising: a first sub-adapter adapted to be directly and electrically connected with a first end of a connector, so as to allow the first end of the connector to be electrically connected to a first cable through the first sub-adapter and to a test equipment through the first cable; and a second sub-adapter adapted to be directly and electrically connected with a second end of the connector, so as to allow the second end of the connector to be electrically connected to a second cable through the second sub-adapter and to the test equipment through the second cable.

According to an exemplary embodiment of the present disclosure, the connector is a coaxial RF connector, and the first cable and the second cable are coaxial RF cables.

According to another exemplary embodiment of the present disclosure, the first sub-adapter comprises: a first external adapter conductor, one end of which is adapted to electrically connect with one end of an external conductor of the connector, and the other end of which is adapted to electrically connect with an external conductor of the first cable; and a first center adapter conductor provided in the first external conductor, and having one end adapted to electrically connect with one end of a center conductor of the connector and other end adapted to electrically with an inner conductor of the first cable.

According to another exemplary embodiment of the present disclosure, the one end of the first external adapter conductor is configured to be threaded to the one end of the external conductor of the connector.

According to another exemplary embodiment of the present disclosure, an external thread is formed on an outer wall of the one end of the external conductor of the connector, and an internal thread is formed on an inner wall of the one end of the first external adapter conductor and configured to mate with the external thread.

According to another exemplary embodiment of the present disclosure, the one end of the first center adapter conductor and the one end of the center conductor of the connector are adapted to be connected together in a plug-in manner.

According to another exemplary embodiment of the present disclosure, the one end of the first center adapter conductor is tubular, the one end of the center conductor of the connector is columnar, so that the one end of the center conductor of the connector is adapted to be inserted into the one end of the first center adapter conductor.

According to another exemplary embodiment of the present disclosure, the first adaptor further comprises a first insulator provided between the first external adapter conductor and the first central adapter conductor, so as to hold the first central adapter conductor in the first external adapter conductor.

According to another exemplary embodiment of the present disclosure, the second sub-adapter comprises: a second external adapter conductor, one end of which is adapted to electrically connect with the other end of the external conductor of the connector, and the other end of which is adapted to electrically connect with an external conductor of the second cable; and a second center adapter conductor provided in the second external conductor, and having one end adapted to electrically connect with the other end of the center conductor of the connector and other end adapted to electrically with an inner conductor of the second cable.

According to another exemplary embodiment of the present disclosure, the one end of the second external adapter conductor is adapted to electrically contact with the other end of the external conductor of the connector.

According to another exemplary embodiment of the present disclosure, a plurality of electrical contacts are formed on the other end of the external conductor of the connector, an end face of the one end of the second external adapter conductor is planar and configured for electrical contact with all of the plurality of electrical contacts on the other end of the external conductor of the connector.

According to another exemplary embodiment of the present disclosure, the one end of the second center adapter conductor is configured for electrical contact with the other end of the center conductor of the connector.

According to another exemplary embodiment of the present disclosure, the one end of the second center adapter conductor is discoid, the other end of the center conductor of the connector is columnar, and an end face of one end of the second center adapter conductor is planar and configured for electrical contact with the other end of the center conductor of the connector.

According to another exemplary embodiment of the present disclosure, the second sub-adapter further comprises a second insulator provided between the second external adapter conductor and the second center adapter conductor, so as to hold the second center adapter conductor in the second external adapter conductor.

According to another exemplary embodiment of the present disclosure, the external conductor of the connector comprises a first external conductor and a second external conductor which are slidably assembled together; the first external adapter conductor of the first sub-adapter is configured for electrical connection with the first external conductor of the connector; and the second external adapter conductor of the second sub-adapter is configured for electrical connection with the second external conductor of the connector.

According to another exemplary embodiment of the present disclosure, the central conductor of the connector comprises a first central conductor and a second central conductor which are slidably assembled together; the first center adapter conductor of the first sub-adapter is configured for electrical connection with the first center conductor of the connector; and the second center adapter conductor of the second sub-adapter is configured for electrical connection with the second center conductor of the connector.

According to another exemplary embodiment of the present disclosure, the connector further comprises an insulator provided between the external conductor and the center conductor, so as to hold the center conductor in the external conductor.

According to another exemplary embodiment of the present disclosure, the connector further comprises an insulating base, and the second external conductor is fixed on the insulating base; a center through hole is formed in the insulating base, and the other end of the center conductor of the connector is exposed through the center through hole.

According to another exemplary embodiment of the present disclosure, the connector further comprises an external elastic element, which is sleeved over the external conductor, such that one end of the external elastic element abuts against the insulating base, and that the other end of the external elastic element abuts against a positioning flange of the first external conductor.

According to another exemplary embodiment of the present disclosure, the connector further comprises an internal elastic element, which is provided in the central conductor, such that one end of the internal elastic element abuts against the first central conductor, and the other end of the internal elastic element abuts against the second central conductor.

According to another exemplary embodiment of the present disclosure, the first sub-adapter is configured for detachable connection with the first end of the connector, and the second sub-adapter is configured for detachable connection with the second end of the connector, so that the connector is capable of being reused.

According to another aspect of the present disclosure, there is provided a connector test system, comprising: the first sub-adapter described herein, one end of which is configured to be electrically connected to a first end of a connector, and the other end of which is electrically connected to a first cable; the second sub-adapter described herein, one end of which is configured to be electrically connected to a second end of the connector, and the other end of which is electrically connected to a second cable; and a test equipment electrically connected to the first sub-adapter and the second sub-adapter via the first cable and the second cable, respectively.

In various exemplary embodiments of the present disclosure, each end of the connector may be directly connected to the adapter, without being connected to the adapter through a circuit board. Therefore, it may effectively eliminate the influence of the circuit board on the test data of the connector, improve the accuracy of the test data of the connector, and reduce the cost.

In addition, in some exemplary embodiments of the present disclosure, the adapter is suitable for detachable connection with the connector, so that the connector may be reused, reducing the design and development cost of the connector.

Other objects and advantages of the present disclosure will be apparent from the following description of the present disclosure with reference to the accompanying drawings, and may help to have a comprehensive understanding of the present disclosure.

### BRIEF DESCRIPTION OF THE DRAWINGS

The above and other features of the present disclosure will become more apparent by describing in detail exemplary embodiments thereof with reference to the accompanying drawings, in which:
Fig. 1 is an illustrative perspective view of a connector according to an exemplary embodiment of the present disclosure;
Fig. 2 is an illustrative longitudinal sectional view of the connector shown in Fig. 1;
Fig. 3 is an illustrative perspective view of a first sub-adapter and a connector according to an exemplary embodiment of the present disclosure;
Fig. 4 is an illustrative longitudinal sectional view of the first sub-adapter and the connector shown in Fig. 3;
Fig. 5 is an illustrative perspective view of a second sub-adapter according to an exemplary embodiment of the present disclosure; and
Fig. 6 is an illustrative longitudinal sectional view of the second sub-adapter shown in Fig. 5.

### DETAILED DESCRIPTION OF PREFERRED EMBODIMENTS

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present disclosure, there is provided a connector adapter, comprising: a first sub-adapter adapted to be directly and electrically connected with a first end of a connector, so that the first end of the connector is allowed to be electrically connected to a first cable through the first sub-adapter and then to a test equipment through the first cable; and a second sub-adapter adapted to be directly and electrically connected with a second end of the connector, so that the second end of the connector is allowed to be electrically connected to a second cable through the second sub-adapter and then to the test equipment through the second cable.

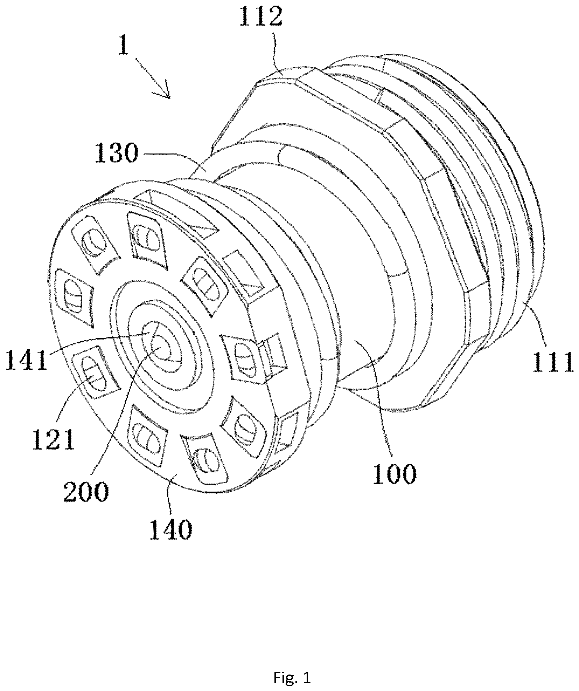

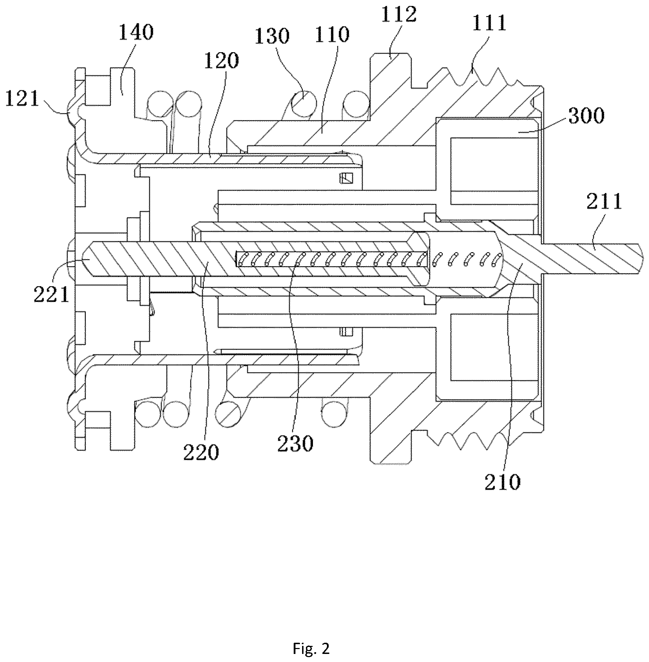

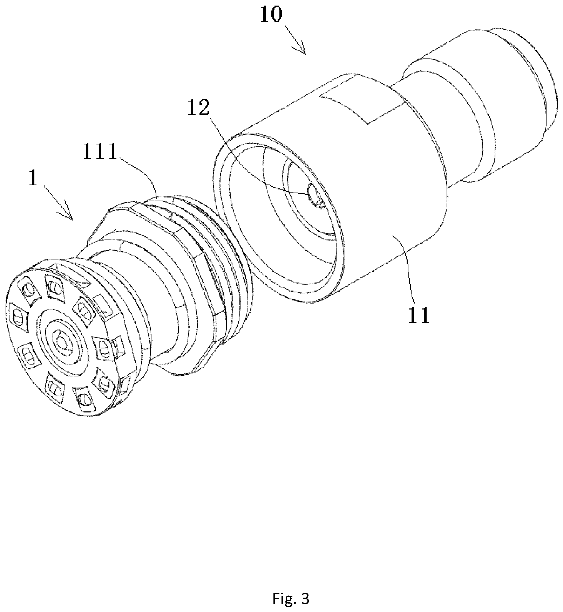

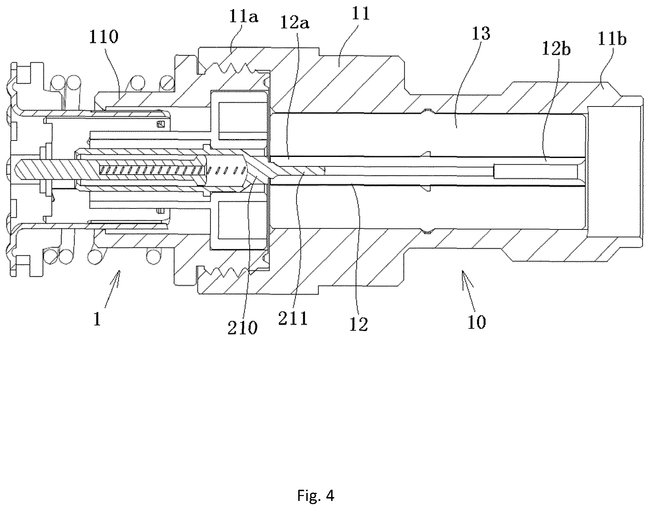

Fig. 1 is an illustrative perspective view of a connector 1 according to an exemplary embodiment of the present disclosure; Fig. 2 is an illustrative longitudinal sectional view of the connector 1 shown in Fig. 1; Fig. 3 is an illustrative perspective view of a first sub-adapter 10 and a connector 1 according to an exemplary embodiment of the present disclosure; and Fig. 4 is an illustrative longitudinal sectional view of the first sub-adapter 10 and the connector 1 shown in Fig. 3.

As shown in Figs. 1 to 4, in an embodiment, the connector adapter 1 comprises a first sub-adapter 10. The first sub-adapter 10 is adapted to be directly and electrically connected with a first end (right end in Fig. 1) of a connector 1, so that the first end of the connector 1 may be electrically connected to a first cable (not shown) through the first sub-adapter 10 and then may be electrically connected to a test equipment (not shown) through the first cable.

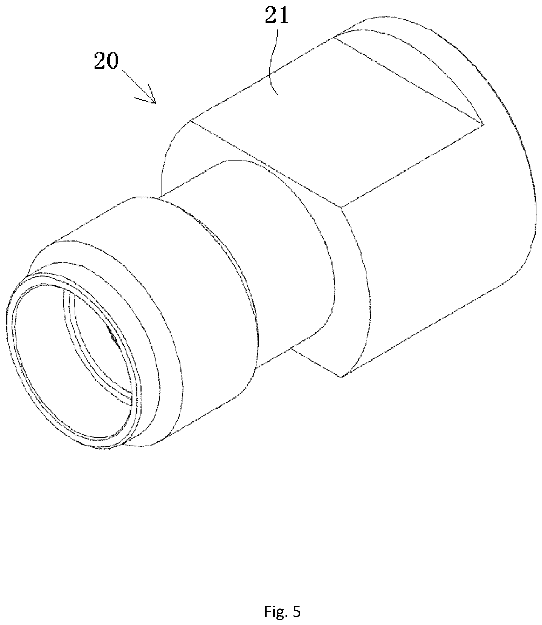

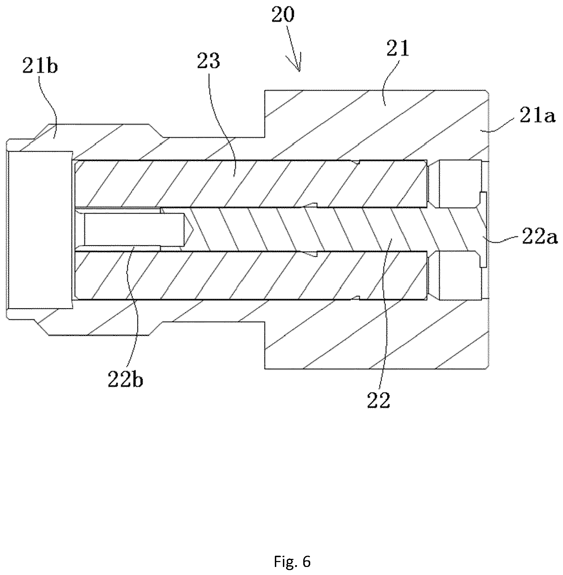

Fig. 5 is an illustrative perspective view of a second sub-adapter 20 according to an exemplary embodiment of the present disclosure; and Fig. 6 is an illustrative longitudinal sectional view of the second sub-adapter 20 shown in Fig. 5.

As shown in Figs. 1-2 and 5-6, in an embodiment, the connector adapter further comprises a second sub-adapter 20. The second sub-adapter 20 is adapted to be directly and electrically connected with a second end of the connector 1, so that the second end of the connector 1 may be electrically connected to a second cable (not shown) through the second sub-adapter 20 and thereby may be electrically connected to the test equipment through the second cable.

As shown in Figs. 1-6, in an embodiment, the connector 1 is a coaxial RF connector, and the first cable and the second cable are coaxial RF cables.

As shown in Figs. 1-4, in an embodiment, the first sub-adapter 10 mainly comprises a first external adapter conductor 11 and a first center adapter conductor 12. One end 11a of the first external adapter conductor 11 is adapted to electrically connect with one end 111 of an external conductor 100 of the connector 1, and the other end 11b of the first external adapter conductor 11 is adapted to electrically connect with an external conductor of the first cable. The first center adapter conductor 12 is provided inside the first external conductor 11. One end 12a of the first center adapter conductor 12 is adapted to electrically connect with one end 211 of a center conductor 200 of the connector 1, and the other end 12b of the first center adapter conductor 12 is adapted to electrically with an inner conductor of the first cable.

As shown in Figs. 1-4, in an embodiment, one end 11a of the first external adapter conductor 11 is threaded to one end 111 of the external conductor 100 of the connector 1.

As shown in Figs. 1-4, in an embodiment, an external thread is formed on an outer wall of one end 111 of the external conductor 100 of the connector 1, and an internal thread is formed on an inner wall of one end 11a of the first external adapter conductor 11 and configured to mate with the external thread.

As shown in Figs. 1-4, in an embodiment, one end 12a of the first center adapter conductor 12 and one end 211 of the center conductor 200 of the connector 1 are adapted to be connected together in a plug-in manner.

As shown in Figs. 1-4, in an embodiment, one end 12a of the first center adapter conductor 12 is tubular, one end 211 of the center conductor 200 of the connector 1 is columnar, and the one end 211 of the center conductor 200 of the connector 1 is adapted to be inserted into the one end 12a of the first center adapter conductor 12.

As shown in Figs. 1-4, in an embodiment, the first adaptor 10 further comprises a first insulator 13 provided between the first external adapter conductor 11 and the first central adapter conductor 12, so as to hold the first central adapter conductor 12 in the first external adapter conductor 11.

As shown in Figs. 1-2 and 5-6, in an embodiment, the second sub-adapter 20 mainly comprises a second external adapter conductor 21 and a second center adapter conductor 22. One end 21a of the second external adapter conductor 21 is adapted to electrically connect with the other end 121 of the external conductor 100 of the connector 1, and the other end 21b of the second external adapter conductor 21 is adapted to electrically connect with an external conductor of the second cable. The second center adapter conductor 22 is provided inside the second external conductor 21. One end 22a of second center adapter conductor 22 is adapted to electrically connect with the other end 221 of the center conductor 200 of the connector 1, and the other end 22b of second center adapter conductor 22 is adapted to electrically with an inner conductor of the second cable.

As shown in Figs. 1-2 and 5-6, in an embodiment, one end 21a of the second external adapter conductor 21 is adapted to electrically contact with the other end 121 of the external conductor 100 of the connector 1.

As shown in Figs. 1-2 and 5-6, in an embodiment, a plurality of electrical contacts are formed on the other end 121 of the external conductor 100 of the connector 1. The end face of one end 21a of the second external adapter conductor 21 is planar, and configured for electrical contact with all of the plurality of electrical contacts on the other end 121 of the external conductor 100 of the connector 1.

As shown in Figs. 1-2 and 5-6, in an embodiment, one end 22a of the second center adapter conductor 22 is configured for electrical contact with the other end 221 of the center conductor 200 of the connector 1.

As shown in Figs. 1-2 and 5-6, in an embodiment, one end 22a of the second center adapter conductor 22 is discoid, while the other end 221 of the center conductor 200 of the connector 1 is columnar. The end face of one end 22a of the second center adapter conductor 22 is planar and configured for electrical contact with the other end 221 of the center conductor 200 of the connector 1.

As shown in Figs. 1-2 and 5-6, in an embodiment, the second sub-adapter 20 further comprises a second insulator 23 provided between the second external adapter conductor 21 and the second center adapter conductor 22, so as to hold the second center adapter conductor 22 in the second external adapter conductor 21.

As shown in Figs. 1-4, in an embodiment, the external conductor 100 of the connector 1 comprises a first external conductor 110 and a second external conductor 120 which are slidably assembled together. The first external adapter conductor 11 of the first sub-adapter 10 is configured for electrical connection with the first external conductor 110 of the connector 1. The second external adapter conductor 21 of the second sub-adapter 20 is configured for electrical connection with the second external conductor 120 of the connector 1.

As shown in Figs. 1-2 and 5-6, in an embodiment, the central conductor 200 of the connector 1 comprises a first central conductor 210 and a second central conductor 220 which are slidably assembled together. The first center adapter conductor 12 of the first sub-adapter 10 is configured for electrical connection with the first center conductor 210 of the connector 1. The second center adapter conductor 22 of the second sub-adapter 20 is configured for electrical connection with the second center conductor 220 of the connector 1.

As shown in Figs. 1-2, in an embodiment, the connector 1 further comprises an insulator 300 provided between the external conductor 100 and the center conductor 200, so as to hold the center conductor 200 in the external conductor 100.

As shown in Figs. 1-4, in an embodiment, the connector 1 further comprises an insulating base 140, and the second external conductor 120 is fixed on the insulating base 140. A center through hole 141 is formed in the insulating base 140, and the other end 221 of the center conductor 100 of the connector 1 is exposed through the center through hole 141.

As shown in Figs. 1-2, in an embodiment, the connector 1 further comprises an external elastic element 130, for example, a spring, which is sleeved on or fitted over the external conductor 100. One end of the external elastic element 130 abuts against the insulating base 140, and the other end of the external elastic element 130 abuts against a positioning flange 112 of the first external conductor 110.

As shown in Figs. 1-2, in an embodiment, the connector 1 further comprises an internal elastic element 230, for example, a spring, which is provided in the central conductor 200. One end of the internal elastic element 230 abuts against the first central conductor 210, and the other end of the internal elastic element 230 abuts against the second central conductor 220.

As shown in Figs. 1-6, in an embodiment, the first sub-adapter 10 is configured for detachable connection with the first end of the connector 1, and the second sub-adapter 20 is configured for detachable connection with the second end of the connector 1. As such, the connector 1 may be easily detached from the first sub-adapter 10 and the second sub-adapter 20 ,so that the connector 1 is capable of being reused.

In another exemplary embodiment of the present disclosure, there is also provided a connector test system. The connector test system mainly comprises the above first sub-adapter 10, the above second sub-adapter 20, and a test equipment (not shown). One end of the first sub-adapter 10 is adapted to be electrically connected to a first end of a connector 1, and the other end of first sub-adapter 10 is electrically connected to a first cable (not shown). One end of the second sub-adapter 20 is adapted to be electrically connected to a second end of the connector 1, and the other end of the second sub-adapter 20 is electrically connected to a second cable (not shown). The test equipment is electrically connected to the first sub-adapter 10 and the second sub-adapter 20 via the first cable and the second cable, respectively.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles and spirit of the disclosure, the scope of which is defined in the claims.

As used herein, an element recited in the singular and proceeded with the word "a" or "an" should be understood as not excluding plural of said elements or steps, unless such exclusion is explicitly stated. Furthermore, references to "one embodiment" of the present disclosure are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A connector adapter, comprising:
a first sub-adapter (10) adapted to be directly and electrically connected with a first end of a connector (1), so as to allow the first end of the connector (1) to be electrically connected to a first cable through the first sub-adapter (10) and to a test equipment through the first cable; and
a second sub-adapter (20) adapted to be directly and electrically connected with a second end of the connector (1), so as to allow the second end of the connector (1) be electrically connected to a second cable through the second sub-adapter (20) and to the test equipment through the second cable.

2. The connector adapter according to claim 1,
wherein the connector (1) is a coaxial RF connector, and the first cable and the second cable are coaxial RF cables; and
wherein the first sub-adapter (10) comprises:
a first external adapter conductor (11), one end (11a) of which is adapted to electrically connect with one end (111) of an external conductor (100) of the connector (1), and the other end (11b) of which is adapted to electrically connect with an external conductor of the first cable; and
a first center adapter conductor (12) provided in the first external conductor (11), and having one end (12a) adapted to electrically connect with one end (211) of a center conductor (200) of the connector (1) and other end (12b) adapted to electrically with an inner conductor of the first cable.

3. The connector adapter according to claim 2,
wherein the one end (11a) of the first external adapter conductor (11) is configured to be threaded to the one end (111) of the external conductor (100) of the connector (1);
optionally, an external thread is formed on an outer wall of the one end (111) of the external conductor (100) of the connector (1), and an internal thread is formed on an inner wall of the one end (11a) of the first external adapter conductor (11) and configured to mate with the external thread.

4. The connector adapter according to claim 2,
wherein the one end (12a) of the first center adapter conductor (12) and the one end (211) of the center conductor (200) of the connector (1) are adapted to connected together in a plug-in manner;
optionally, the one end (12a) of the first center adapter conductor (12) is tubular, the one end (211) of the center conductor (200) of the connector (1) is columnar, so that the one end (211) of the center conductor (200) of the connector (1) is adapted to be inserted into the one end (12a) of the first center adapter conductor (12).

5. The connector adapter according to claim 2,
wherein the first adaptor (10) further comprises a first insulator (13) provided between the first external adapter conductor (11) and the first central adapter conductor (12), so as to hold the first central adapter conductor (12) in the first external adapter conductor (11).

6. The connector adapter according to claim 2, wherein the second sub-adapter (20) comprises:
a second external adapter conductor (21), one end (21a) of which is adapted to electrically connect with the other end (121) of the external conductor (100) of the connector (1), and the other end (21b) of which is adapted to electrically connect with an external conductor of the second cable; and
a second center adapter conductor (22) provided in the second external conductor (21), and having one end (22a) adapted to electrically connect with the other end (221) of the center conductor (200) of the connector (1) and other end (22b) adapted to electrically with an inner conductor of the second cable.

7. The connector adapter according to claim6,
wherein the one end (21a) of the second external adapter conductor (21) is adapted to electrically contact with the other end (121) of the external conductor (100) of the connector (1).

8. The connector adapter according to claim 7,
wherein a plurality of electrical contacts are formed on the other end (121) of the external conductor (100) of the connector (1), and the one end (21a) of the second external adapter conductor (21) has a planar end face configured for electrical contact with all of the plurality of electrical contacts on the other end (121) of the external conductor (100) of the connector (1).

9. The connector adapter according to claim 6,
wherein the one end (22a) of the second center adapter conductor (22) is configured for electrical contact with the other end (221) of the center conductor (200) of the connector (1).

10. The connector adapter according to claim 9,
wherein the one end (22a) of the second center adapter conductor (22) is discoid, the other end (221) of the center conductor (200) of the connector (1) is columnar, and the one end (22a) of the second center adapter conductor (22) has a planar end face configured for electrical contact with the other end (221) of the center conductor (200) of the connector (1).

11. The connector adapter according to claim 6,
wherein the second sub-adapter (20) further comprises a second insulator (23) provided between the second external adapter conductor (21) and the second center adapter conductor (22), so as to hold the second center adapter conductor (22) in the second external adapter conductor (21).

12. The connector adapter according to claim 6,
wherein the external conductor (100) of the connector (1) comprises a first external conductor (110) and a second external conductor (120) which are slidably assembled together;
wherein the first external adapter conductor (11) of the first sub-adapter (10) is configured for electrical connection with the first external conductor (110) of the connector (1); and
wherein the second external adapter conductor (21) of the second sub-adapter (20) is configured for electrical connection with the second external conductor (120) of the connector (1).

13. The connector adapter according to claim 12,
wherein the central conductor (200) of the connector (1) comprises a first central conductor (210) and a second central conductor (220) which are slidably assembled together;
wherein the first center adapter conductor (12) of the first sub-adapter (10) is configured for electrical connection with the first center conductor (210) of the connector (1); and
wherein the second center adapter conductor (22) of the second sub-adapter (20) is configured for electrical connection with the second center conductor (220) of the connector (1).

14. The connector adapter according to claim 1,
wherein the first sub-adapter (10) is configured for detachable connection with the first end of the connector (1), and the second sub-adapter (20) is configured for detachable connection with the second end of the connector (1), so as to eanble reuse of the connector (1).

15. A connector test system, comprising:
the first sub-adapter (10) defined in any one of claims 1-14, one end of which is configured to be electrically connected to a first end of a connector (1), and the other end of which is electrically connected to a first cable;
the second sub-adapter (20) defined in any one of claims 1-14, one end of which is configured to be electrically connected to a second end of the connector (1), and the other end of which is electrically connected to a second cable; and
a test equipment electrically connected to the first sub-adapter (10) and the second sub-adapter (20) via the first cable and the second cable, respectively.
